Europäisches Patentamt

European Patent Office

Office européen des brevets

(11) Publication number: **0 107 773**
**B1**

# (12) EUROPEAN PATENT SPECIFICATION

(45) Date of publication of patent specification: **11.03.87**

(21) Application number: **83109015.4**

(22) Date of filing: **13.09.83**

(51) Int. Cl.⁴: **H 01 L 29/74,** H 01 L 29/52, H 01 L 29/08

(54) Thyristor with turn-off capability.

(30) Priority: **04.10.82 US 432614**

(43) Date of publication of application:
**09.05.84 Bulletin 84/19**

(45) Publication of the grant of the patent:
**11.03.87 Bulletin 87/11**

(84) Designated Contracting States:
**DE FR GB**

(56) References cited:
**EP-A-0 008 008**
**EP-A-0 039 941**
**EP-A-0 081 642**
**DE-B-2 625 917**

**SOLID-STATE ELECTRONICS, vol. 23, no. 11, 1980, Oxford J. HOMOLA et al. "Turn-off-type field-controlled thyristor", pages 1101-1105**

(73) Proprietor: **GENERAL ELECTRIC COMPANY**
**1 River Road**
**Schenectady New York 12305 (US)**

(72) Inventor: **Temple, Victor Albert Keith**
**Main Street**
**Clifton Park New York 12065 (US)**

(74) Representative: **Kinne, Reinhard, Dipl.-Ing. et al**
**Patentanwaltsbüro Tiedtke-Bühling-Kinne-Grupe-Pellmann-Grams-Struif Bavariaring 4**
**D-8000 München 2 (DE)**

Courier Press, Leamington Spa, England.

Description

The present invention relates to a thyristor with turn-off capability.

A thyristor of this type is described in EP—A—81 642 which corresponds to US-application 391 620, filed June, 24, 1982 and is comprised in the state of the art pursuant to Art. 54(3) EPC only. This known thyristor comprises a P⁺ emitter region, a N⁻ base region, a P base region and an N⁺ emitter region, along with an anode connected to the P⁺ emitter region and a cathode connected to the N⁺ emitter region. Furthermore there is provided an integrated MOS structure which is effective to create an inversion channel in the N⁺ emitter region that completes a distributed current path from the P base region of the device to a further P⁺ region of the thyristor, which is ohmically connected to the cathode. This inversion channel is conductive to holes, whereby the hole current flowing therein from the P base region to the cathode (via the further P⁺ region) facilitates turn-off of the thyristor.

This known thyristor, however, is disadvantageous in that the inclusion of the further P⁺ region in the thyristor necessitates a critical alignment of a photolithographic mask in forming such region. The exact alignment of the mask is not easy to obtain so that the yield of usable thyristors is decreased and the costs of production accordingly are increased.

In EP—A—39 941 there is described a thyristor having first, second, third and fourth regions successively joined together and arranged in alternate conductivity types, and first and second electrodes respectively adjoining the first and fourth region. Furthermore there are provided MOS means for transporting majority carriers from the third region to the second electrode, the MOS means being constituted of an insulating layer adjoining the fourth region, wherein a portion of the second electrode adjoins the fourth region. A gate electrode is situated adjacent the fourth region and the portion of the second electrode, but spaced from the fourth by the insulating layer. The thyristor of this type is intended to offer both a good stability and the ability to allow great current densities.

It is an object of the present invention to provide a thyristor with turn-off capability according to claim 1 which does not require a further distinct semiconductor region in a current path extending from the base region to the cathode.

According to the invention this object is achieved by the measures specified in claim 1.

According to the invention there is no need for a further semiconductor region in the current path extending from the base region to the cathode, so that the critical alignment of the photolithographic mask in forming such region can be omitted. Therefore the yield of usable thyristors is increased and the costs of producing the device are accordingly decreased.

Advantageous embodiments of the invention are subject-matter of the sub-claims.

In the following the invention will be described in more detail with reference to the sole drawing Figure. In this description the thyristor will be conveniently referred to as a metal-oxide-semiconductor turn-off thyristor or shortly as "MOSTOT". It furthermore will be understood, as is known in the art, that a thyristor complementary in structure to that described in the following can be fabricated by substituting P-type material for N-type material, and vice-versa.

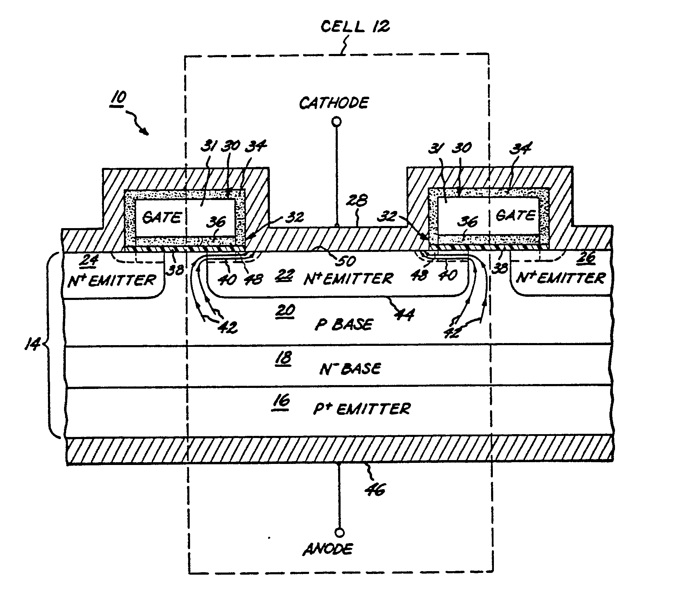

There is illustrated in the Figure a cross-section of a portion of a MOSTOT 10 according to the invention. Such illustrated portion of MOSTOT 10 includes a cell or repeated structure 12, which is typically round or rectangular as viewed from above the device. Many cells identical to cell 12 are typically included in MOSTOT 10. MOSTOT 10 includes a body 14 of semiconductor material, preferably silicon. In the illustrated embodiment, body 14 includes a first region in the form of a P⁺ emitter region 16, a second region in the form of an N⁻ base region 18, a third region in the form of a P base region 20, and a fourth region in the form of an N⁺ emitter region 22, as well as further N⁺ emitter regions, such as regions 24 and 26, for further cells. MOSTOT 10 has a doping profile, taken vertically through regions 16, 18, 20, and 22, which is selected to yield good thyristor performance. By way of example, a suitable doping profile for MOSTOT 10 is illustrated in Figure 2(a) of S. M. Sze, *Physics of Semiconductor Devices*, New York: Wiley-Interscience (1969) at page 322.

Cell 12 includes MOS structure 30 for transporting holes from P base region 20 to cathode 28, so as to facilitate turn-off of MOSTOT 10. MOS structure 30 comprises a gate electrode 31, an insulating layer 32 having component layers 34, 36, and 38, and portion 40 of N⁺ emitter region 22, which is in the vicinity of gate electrode 31. Gate electrode 31 preferably comprises a conductive refractory material such as highly-doped polysilicon or molybdenum silicide, known conductive equivalents to metal. Component insulating layers 34 and 36 preferably each comprise an oxide of semiconductor material, while component layer 38 preferably comprises silicon nitride, a known dielectric equivalent of oxide, to facilitate the fabrication of MOSTOT 10, as discussed below.

As will be understood by those skilled in the art, biasing of gate electrode 30 with a negative voltage above a threshold magnitude results in portion 40 of N⁺ emitter region 22 becoming "inverted", or more populated by holes than electrons, so as to become conductive to holes. The inversion channel thus formed in N⁺ emitter portion 40 constitutes part of a distributed current path 42, which extends from the interior of P base region 20 to cathode 28, via the inversion channel in N⁺ emitter portion 40. If, through biasing of gate electrode 31, the electric field induced in further portion 48 of N⁺ emitter region 22 is sufficiently strong, then such further portion 48 becomes inverted and, together with the inversion channel in portion 40, completes distributed current path 42 from P base region 20 to cathode 28. However, in a typical embodiment of MOSTOT 10, the electric field in portion 48 is not strong enough to invert portion 48. Rather, the electric field in portion 48 is only sufficient to deplete portion 48 of mobile electrons, but not to cause portion 48 to become more populated by holes than electrons. Such depleted condition of portion 48 will be understood by those skilled in the art as depletion region punch-through in portion 48 from portion 40 to cathode 28.

Various measures can be taken for ensuring the attainment of such punch-through of the depletion region in $N^+$ emitter portion 48, and, if desired, the extension of the inversion channel in $N^+$ emitter region 22 from portion 40 into portion 48. First, the thickness of insulating layer 34 between gate electrode 31 and cathode 28 can be minimized, provided that the dielectric function of layer 34 is not impaired. Similarly, the thickness of insulating layers 36 and 38 can be minimized, provided that the dielectric function of these layers is not impaired. Further, the magnitude of the biasing voltage on gate electrode 31 can be maximized, provided that the dielectric function of insulating layer 32, which surrounds gate electrode 31, is not impaired. Additionally, the dopant concentration of portion 48 can be limited so as to decrease the level of biasing voltage on gate electrode 31 at which portion 48 becomes depleted of electrons. A preferred dopant concentration for portion 48 is below about $10^{17}$ impurity atoms per cubic centimeter, although it could suitably be as high as about $10^{18}$ impurity atoms per cubic centimeter in some embodiments of MOSTOT 10.

Limiting the dopant concentration of $N^+$ emitter portion 48 to attain the foregoing purpose is likely to result in the portion of junction 50 between portion 48 and cathode 28 constituting a Schottky barrier rectifying contact for electrons. To insure proper functioning of MOSTOT 10, at least part of junction 50, between $N^+$ emitter region 22 and cathode 28, must form an ohmic contact. This requires that at least some portion of $N^+$ emitter region 22 adjoining cathode 28 at junction 50 have a dopant concentration in excess of about $10^{17}$ impurity atoms per cubic centimeter, and, preferably, above about $10^{19}$ impurity atoms per cubic centimeter, due to a localized $N^+$ diffusion in region 22, for example.

Junction 50 must not constitute a Schottky barrier rectifying contact for holes; otherwise, distributed current path 42 would not be complete. Accordingly, cathode 28 must comprise a conductive material with a low work function, such as aluminum or titanium. Conversely, if a complementary MOSTOT 10 were fabricated, in which N-type material were used instead of P-type material, and vice-versa, and its corresponding bypass current path were conductive to electrons rather than holes, its cathode would need to comprise a conductive material with a high work function, such as gold or platinum, so as to avoid a Schottky rectifying barrier to electrons.

Cell 12 of MOSTOT 10 can be turned off when distributed current path 42 has a resistance sufficiently low to prevent P—N junction 44, between P base region 20 and $N^+$ emitter region 22, from becoming forward biased, owing to hole current flow in current path 42, by more than about one-half of the energy bandgap voltage of the semiconductor material forming P—N junction 44 (i.e., about 1.0 volt in silicon). If the resistance of current path 42 exceeds such a value, cell 12 cannot turn-off, at least without commutation (i.e., by reversal of the anode 46-to-cathode 28 voltage of MOSTOT 10). In the latter case, turn-off of cell 12 is markedly faster than by commutation alone. In order for the entire MOSTOT 10 to turn-off, each of its cells must turn-off.

In fabricating MOSTOT 10, $P^+$ emitter region 16, $N^-$ base region 18, and P base region 20 are suitably fabricated using conventional techniques for making thyristors. The MOS structure for transporting holes from P base region 20 to cathode 28, which includes gate electrode 31 and insulating layer 32, is suitably fabricated in the following, exemplary manner. Silicon nitride layer 38, oxide layer 36, and gate electrode layer 31 are sequentially formed across the entire upper surface of the illustrated portion of semiconductor body 142, preferably by low pressure chemical deposition. Gate electrode 31 and oxide layer 36 are then photolithographically patterned to remove undesired portions thereof, leaving intact the illustrated portions of gate electrode 31 and oxide layer 36. Oxide layer 34 is then formed on gate electrode 31, preferably by thermal growth. Oxide layer 34, at least where it is thermally grown, does not grow on silicon nitride layer 38, even though the lower portions thereof appear to do so in the schematic drawings. Next, silicon nitride layer 38 is selectively removed, as by etching, so as to leave intact only the illustrated portions thereof. Layer 38 could alternatively be implemented by a material other than silicon nitride which likewise resists oxidation and can be removed without removing oxide. The presence of these characteristics in layer 38 facilitates the fabrication of MOSTOT 10 by minimizing the number of photolithographic masking steps required.

Gate electrode 31, along with insulating layer 32, is then used as a mask for forming $N^+$ emitter regions 22, 24 and 26 in the upper portion of semiconductor body 14, preferably by diffusion, with the remainder of the illustrated portion of the upper surface of body 14 being unmasked or exposed. While carrying out such $N^+$ diffusions, the thermal growth of oxide on the exposed portions of the upper surface of semiconductor body 14 should be minimized, in order that such oxide can be removed without reducing the thickness of oxide layer 34 to such an extent that the dielectric capability thereof is impaired.

The foregoing describes a thyristor having MOS structure for transporting, in a distributed current path, majority carriers from inner base region of the device to a main current-carrying electrode of the device, wherein the thyristor does not require a further region in such distributed current path.

While the invention has been described with respect to specific embodiments, many modifications and substitutions will occur to those skilled in the art. For example, complementary MOS structure for removing majority carriers from an inner base region of the device could additionally be fabricated on the lower surface of the thyristor described herein.

## Claims

1. A thyristor comprising a body of semiconductor material having first, second, third and fourth regions (16, 18, 20, 22) successively joined together and arranged in alternate conductivity types, and first and second electrodes (46, 28) respectively adjoining said first and fourth regions, an MOS structure for transporting majority carriers from said third region to said second electrode along a current path, said MOS structure comprising:

(a) an insulating layer (32) on a portion of said fourth region and a portion of said second electrode; and

(b) a gate electrode (31) situated above the said portion of the fourth region and adjacent to said portion of said second electrode, but spaced from the said portion of the fourth region and said portion of said second electrode by said insulating layer, said current path being constituted by a portion of the said third region and the said portion of the fourth region and the MOS structure being adapted to produce an inversion channel in the said portion of the fourth region during turn-off of the thyristor whereby the inversion channel constitutes a part of the said current path.

2. The thyristor according to claim 1 wherein said insulating layer comprises silicon nitride adjoining said fourth region.

3. The thyristor according to claim 2 wherein said insulation layer additionally comprises a thermally-grown oxide of said gate electrode.

4. The thyristor according to claim 1 wherein the dopant concentration of the portion of said fourth region in the vicinity of said portion of said second electrode is below about $10^{18}$ impurity atoms per cubic centimeter.

5. The thyristor according to claim 1 wherein the dopant concentration of the portion of said fourth region in the vicinity of said portion of said second electrode is below about $10^{17}$ impurity atoms per cubic centimeter.

6. The thyristor according to claim 1 wherein said first and third regions comprise P-type semiconductor material and said second and fourth regions comprise N-type semiconductor material.

7. The thyristor according to claim 6 wherein said semiconductor body comprises silicon.

8. The thyristor according to claim 1 wherein said first, second, third and fourth regions each comprises a layer parallel to a major surface of said semiconductor body.

9. The thyristor according to claim 1 wherein said gate electrode is situated adjacent a terminated portion of the junction between said third and fourth regions, but is spaced therefrom by said insulating layer.

10. The thyristor according to claim 1 wherein said gate electrode comprises a conductive refractory material.

11. The thyristor according to claim 1 wherein said gate electrode comprises highly-doped polysilicon.

## Patentansprüche

1. Thyristor mit einem Körper aus Halbleitermaterial, die eine erste, zweite, dritte und vierte Region (16, 18, 20, 22) aufweist, welche aufeinanderfolgend aneinandergefügt und in abwechselnden Leitfähigkeitstypen angeordnet sind, mit einer ersten und zweiten Elektrode (46, 28), die an die erste bzw. vierte Region angrenzen, sowie mit einer MOS-Struktur zum Transport von Majoritätsträgern aus der dritten Region zu der zweiten Elektrode entlang eines Strompfads, dadurch gekennzeichnet, daß die MOS-Struktur

(a) eine isolierende Schicht (32) auf einem Bereich der vierten Region und einen Bereich der zweiten Elektrode sowie

(b) eine oberhalb des Bereichs der vierten Region befindliche und an den Bereich der zweiten Elektrode angrenzende, von dem Bereich der vierten Region und dem Bereich der zweiten Elektrode hingegen durch die isolierende Schicht beabstandete Gateelektrode (31) aufweist, wobei der Strompfad von einem Bereich der dritten Region und dem Bereich der vierten Region gebildet wird und die MOS-Struktur dazu eingerichtet ist, während des Ausschaltens des Thyristors in den Bereich der vierten Region einen Inversionskanal zu erzeugen, wobei der Inversionskanal einen Teil des Strompfads bildet.

2. Thyristor nach Anspruch 1, dadurch gekennzeichnet, daß die isolierende Schicht an die vierte Region angrenzendes Siliziumnitrid aufweist.

3. Thyristor nach Anspruch 2, dadurch gekennzeichnet, daß die isolierende Schicht zusätzlich thermisch aufgewachsenes Oxid der Gateelektrode aufweist.

4. Thyristor nach Anspruch 1, dadurch gekennzeichnet, daß die Dotierungskonzentration des Bereichs der vierten Region in der Nähe des Bereichs der zweiten Elektrode kleiner als ungefähr $10^{18}$ Verunreinigungsatome pro Kubikzentimeter ist.

5. Thyristor nach Anspruch 1, dadurch gekennzeichnet, daß die Dotierungskonzentration des Bereichs der vierten Region in der Nähe des Bereichs der zweiten Elektrode kleiner als ungefähr $10^{17}$ Verunreinigungsatome pro Kubikzentimeter ist.

6. Thyristor nach Anspruch 1, dadurch gekennzeichnet, daß die erste und dritte Region P-Halbleitermaterial und zweite und vierte Region N-Halbleitermaterial enthalten.

7. Thyristor nach Anspruch 6, dadurch gekennzeichnet, daß der Halbleiterkörper Silizium enthält.

8. Thyristor nach Anspruch 1, dadurch gekennzeichnet, daß die erste, zweite und dritte vierte Region jeweils eine zu einer Hauptoberfläche des Halbleiterkörpers parallele Schicht aufweisen.

9. Thyristor nach Anspruch 1, dadurch gekennzeichnet, daß die Gateelektrode nahe einem abgeschlossenen Bereich des übergangs zwischen der dritten und vierten Region angeordnet, von diesem jedoch durch die isolierende Schicht beabstandet ist.

10. Thyristor nach Anspruch 1, dadurch gekennzeichnet, daß die Gateelektrode ein schwer schmelzbares leitendes Material enthält.

11. Thyristor nach Anspruch 1, dadurch gekennzeichnet, daß die Gateelektrode hoch dotiertes Polysilizium enthält.

## Revendications

1. Thyristor comprenant un corps de matériau semiconducteur ayant des première, seconde, troisième et quatrième régions (16, 18, 20, 22) réunies successivement ensemble et disposées en types de conductivité alternés, et des première et seconde électrodes (46, 28) réunissant respectivement les première et quatrième régions, une structure MOS pour transporter des porteurs majoritaires entre la troisième région et la seconde électrode suivant un trajet de courant, cette structure MOS comprenant:

(a) une couche isolante (32) sur une partie de la quatrième région et une partie de la seconde électrode; et

(b) une électrode de grille (31) située au-dessus de la partie de la quatrième région et contiguë à la partie de la seconde électrode, mais espacée de la partie de la quatrième région et de la partie de la seconde électrode par la couche isolante, le trajet de courant étant constitué par une portion de la troisième région et la partie de la quatrième région et la structure MOS étant destinée à produire un canal d'inversion dans la partie de la quatrième région pendant le blocage du thyristor, d'où il résulte que le canal d'inversion constitue une partie du trajet de courant.

2. Thyristor selon la revendication 1, dans lequel la couche isolante comprend du nitrure de silicium jouxtant la quatrième région.

3. Thyristor selon la revendication 2, dans lequel la couche isolante comprend un outre un oxyde, ayant subi une croissance thermique de l'électrode de grille.

4. Thyristor selon la revendication 1, dans lequel la concentration de dopant de la partie de la quatrième région dans le voisinage de la partie de la seconde électrode est inférieure à environ $10^{18}$ atomes d'impuretés par centimètre cube.

5. Thyristor selon la revendication 1, dans lequel la concentration en dopant de la partie de la quatrième région dans le voisinage de la partie de la seconde électrode est inférieure à environ $10^{17}$ atomes d'impuretés par centimètre cube.

6. Thyristor selon la revendication 1, dans lequel les première et troisième régions comprennent un matériau semiconducteur du type P et les seconde et quatrième régions comprennent un matériau semi-conducteur du type N.

7. Thyristor selon la revendication 6, dans lequel le corps semi-conducteur comprend du silicium.

8. Thyristor selon la revendication 1, dans lequel les première, seconde, troisième et quatrième régions comprennent chacune une couche parallèle à une surface principale du corps semi-conducteur.

9. Thyristor selon la revendication 1, dans lequel l'électrode de grille est située en un endroit contigu à une partie finale de la jonction entre les troisième et quatrième régions, mais en est espacée par la couche isolante.

10. Thyristor selon la revendication 1, dans lequel l'électrode de grille comprend un matériau réfractaire conducteur.

11. Thyristor selon la revendication 1, dans lequel l'électrode de grille comprend du polysilicium hautement dopé.

CELL 12

CATHODE

10

31 30 34

31 30 34

GATE
36

GATE
36

32

28

32

24
N⁺ EMITTER

38

50

38

26
N⁺ EMITTER

40 48

22 N⁺ EMITTER

48 40

42

20 P BASE

44

42

18 N⁻ BASE

16 P⁺ EMITTER

14

46

ANODE